# EUROPÄISCHE PATENTSCHRIFT

(11) **EP 1 488 458 B1**
(45) Veröffentlichungstag und Bekanntmachung des Hinweises auf die Patenterteilung: **27.06.2007**
(21) Anmeldenummer: 03744378.5
(22) Anmeldetag: 18.03.2003
(51) Int. Cl.: H01L 27/142, H01L 31/12

(54) **SELBSTJUSTIERENDE SERIENVERSCHALTUNG VON DÜNN- UND DICK-SCHICHTEN UND VERFAHREN ZUR HERSTELLUNG**
AUTOMATICALLY ADJUSTING SERIAL CONNECTIONS OF THICK AND THIN LAYERS AND METHOD FOR THE PRODUCTION THEREOF
CONNEXION EN SERIE A AJUSTAGE AUTOMATIQUE DE COUCHES MINCES ET DE COUCHES EPAISSES ET PROCEDE POUR REALISER LADITE CONNEXION

(30) Priorität: 19.03.2002 EP 02006161
(43) Veröffentlichungstag der Anmeldung: 22.12.2004
(73) Patentinhaber: Scheuten Glasgroep, 5900 AA Venlo (NL)
(72) Erfinder: GEYER, Volker, 41372 Niederkrüchten (DE)
(74) Vertreter: Jostarndt, Hans-Dieter
(86) Internationale Anmeldenummer: PCT/EP2003/002865
(87) Internationale Veröffentlichungsnummer: WO 2003/079432

(56) Entgegenhaltungen:
- EP-A- 0 443 348
- EP-A- 0 853 345
- WO-A-96/30935
- DE-A- 3 727 825
- PATENT ABSTRACTS OF JAPAN vol. 010, no. 192 (E-417), 5. Juli 1986 (1986-07-05) & JP 61 035573 A (MATSUSHITA ELECTRIC IND CO LTD), 20. Februar 1986 (1986-02-20)
- BASOL B M ET AL: "Flexible and light weight copper indium diselenide solar cells" 25TH IEEE PHOTOVOLTAIC SPECIALISTS CONFERENCE, 13. - 17. Mai 1996, Seiten 157-162, XP010208116 Washington, USA
- PROBST V ET AL: "Rapid CIS-process for high efficiency PV-modules: development towards large area processing" THIN SOLID FILMS, ELSEVIER-SEQUOIA S.A. LAUSANNE, CH, Bd. 387, Nr. 1-2, 29. Mai 2001 (2001-05-29), Seiten 262-267, XP004232966 ISSN: 0040-6090
- PATENT ABSTRACTS OF JAPAN vol. 011, no. 374 (E-562), 5. Dezember 1987 (1987-12-05) & JP 62 142368 A (FUJI ELECTRIC CO LTD), 25. Juni 1987 (1987-06-25)

## Beschreibung

Die Erfindung betrifft eine selbstjustierende Serienverschaltung von Dünn- und Dickschichten und ein Verfahren zur Herstellung.

In der Industrie besteht ein zunehmender Bedarf nach Verfahren zur Herstellung von Serienverschaltungen von Dünn- und Dickschichten, doch insbesondere in der Photovoltaik ist das Problem der Serienverschaltung von Dünn- und Dickschichtzellen noch nicht zufriedenstellend gelöst.

Die bekannteste Methode zum Herstellen von Serienverschaltungen von Dünnschichten ist das Aufbringen der einzelnen Schichten, unterbrochen von Prozessschritten, bei denen die aufgebrachte Schicht durch Laser oder mechanische Mittel getrennt wird. Typischerweise sind hierfür mehrere Bearbeitungsschritte erforderlich, bei denen die jeweils aufgebrachte Schicht durch Trennschnitte mit Unterbrechungen versehen wird.

Derartige Herstellungsverfahren weisen verschiedene Nachteile auf. Da die Schnitte, um tote Flächen zu minimieren, sehr nah beieinander liegen müssen, sich aber nicht überlappen oder kreuzen dürfen, da dies sonst zu Kurzschlüssen oder Fehlern führt, ist beispielsweise eine extrem genaue Ausrichtung des Substrats erforderlich. Ferner muss zur Realisierung eines Inline-Prozesses für jeden durchzuführenden Schnitt eine entsprechende Station eingerichtet werden. Wird das Verfahren dagegen nicht in einem Inline-Prozess durchgeführt, muss das Substrat für jeden Schnitt zu einer Schnittstation transportiert werden.

Aus der internationalen Patentanmeldung WO 96/30935 ist ein Verfahren zur Herstellung von mehrschichtigen elektronischen Bauteilen bekannt, bei dem abwechselnd elektrisch leitfähige und isolierende Schichten aufgebracht werden. Dabei wird ein Substrat verwendet, auf dessen Oberfläche sich Stege mit rechteckigem Querschnitt befinden, so dass eine gerichtete Schichtdeposition unter einem Einfallswinkel eine Abschattung von Bereichen zwischen den Stegen bewirkt.

Die europäische Patentanmeldung EP 0 853 345 A1 beschreibt ein Verfahren zur Bildung von CdTe-Schichten bei der Herstellung von Solarzellen. Die CdTe-Schichten werden durch Sublimationsverfahren aufgebracht, wobei die Materialquelle für ein derartiges Verfahren so gebildet wird, dass ein Pulver aus CdTe-Pulver und weiteren Bestandteilen zu einer Paste gemischt wird, welche auf ein Substrat aufgetragen wird. Dieses Quellsubstrat wird in einem festen Abstand so gegenüber einem zu beschichtenden Substrat angeordnet, dass sich bei Erwärmung des Quellsubstrats eine CdTe-Schicht auf dem gegenüberliegenden Substrat ausbildet.

Aus der deutschen Offenlegungsschrift DE 37 27 825 A1 ist ein Verfahren zur Herstellung eines serienverschalteten Dünnschichtsolarmoduls aus kristallinem Silizium bekannt, bei dem auf ein großflächiges Substrat schmale Stege aufgebracht und diese nacheinander mit verschiedenen Funktionsschichten beschichtet werden. Um bestimmte Bereiche frei von Deposistionsmaterial einer Schicht zu halten, werden beispielsweise Masken-, Polier-, Ätz- oder Lasertechniken angewendet.

Aufgabe der Erfindung ist es, ein gattungsgemäßes Verfahren zur Herstellung von selbstjustierenden Serienverschaltungen von Dünn- und/oder Dickschichten so weiterzuentwickeln, dass es die Nachteile herkömmlicher Herstellungsverfahren vermeidet und wenige und möglichst einfach durchzuführende Verfahrensschritte aufweist.

Ferner ist es Aufgabe der Erfindung, eine selbstjustierende Serienverschaltung von Dünn- und/oder Dickschichten bereitzustellen, die durch wenige und möglichst einfach durchzuführende Verfahrensschritte hergestellt werden kann.

Erfindungsgemäß wird diese Aufgabe dadurch gelöst, dass elektrisch leitfähige Leiterbahnen auf ein Substrat aufgebracht werden und das Substrat unter verschiedenen Einfallswinkeln mehreren Schichtdepositionen aus leitfähigen, halbleitenden und/oder isolierenden Materialien ausgesetzt wird.

Beim Aufbringen der Schichtdepositionen unter verschiedenen Winkeln werden unterschiedliche Bereiche zwischen den Leiterbahnen abgeschattet und sind so der jeweiligen Materialdeposition nicht ausgesetzt.

Die Aufgabe wird ferner dadurch gelöst, dass zusätzlich zu den Schichtdepositionen unter einem Winkel weitere Schichten aufgebracht werden, zu denen insbesondere eine Hauptschicht aus kornförmigen Partikeln zählt.

Diese Schicht aus Körnern stellt den Halbleiter der Serienverschaltung dar und ist als Dickschicht zu bezeichnen, da sie im Gegensatz zu den aufgebrachten Dünnschichten mit Dicken in der Größenordnung von 50 nm bis 50 µm eine Dicke der Größenordnung 10 µm bis 200 µm aufweist. Die aus dem erfindungsgemäßen Verfahren resultierende Serienverschaltung stellt also eine Verschaltung von Dünn- und Dickschichten dar, durch die ein Stromfluss stattfinden kann.

Die auf das Substrat aufgebrachten Leiterbahnen haben vorzugsweise einen rechteckigen Querschnitt, es sind aber auch andere Querschnittsgeometrien möglich. Beispielsweise können die Leiterbahnen einen dreieckigen, trapezförmigen oder runden Querschnitt aufweisen. Die Leiterbahnen werden auf eine Substratfläche aufgebracht, bei der es sich beispielsweise um Glas handeln kann. Nach Aufbringen der Leiterbahnen wird das Substrat nacheinander verschiedenen Beschichtungen und Bearbeitungsschritten ausgesetzt. Dazu zählen wenigstens mehrere Schichtdepositionen unter einem Aufbringungswinkel im Bezug zur Substratoberfläche und die Ausbildung einer Halbleiterschicht durch das Aufbringen von kornförmigen Partikeln.

Die Richtung der jeweiligen Deposition unter einem Winkel steht vorzugsweise senkrecht zur Längsausrichtung der Leiterbahnen und in einem Winkel zur Oberfläche des Substrats, so dass zwischen den Leiterbahnen Bereiche entstehen, die von den Leiterbahnflanken abgeschattet werden und somit keiner Deposition ausgesetzt sind.

In einer besonders bevorzugten Ausführungsform der Erfindung werden für eine Serienverschaltung von Dünn- und Dickschichten wenigstens drei Hauptschichten unter verschiedenen Winkeln im Bezug zur Substratoberfläche und eine Schicht aus Körnern aufgebracht. Die Hauptschichten können aus verschiedenen Einzelschichten bestehen, die vorzugsweise unter einem der jeweiligen Schicht gemeinsamen Winkel aufgebracht wurden. Ferner können die Hauptschichten durch weitere Schichten und Prozessschritte unterbrochen oder ergänzt sein, die zur Ausbildung einer Serienverschaltung erforderlich sind.

Im Folgenden wird ein besonders bevorzugtes Ausführungsbeispiel einer Serienverschaltung bestehend aus vier Hauptschichten beschrieben, wobei drei Hauptschichten unter einem Winkel aufgebracht werden und eine Hauptschicht aus Körnern besteht. Die vier Hauptschichten werden durch weitere Schichten ergänzt, die zur Ausbildung einer Serienverschaltung der Schichten erforderlich sind. Dazu werden auf ein Substrat elektrisch leitfähige Leiterbahnen aufgebracht, woraufhin die erste Hauptschicht aufgebracht wird. Bei dieser Schicht handelt es sich um einen Rückkontakt aus einem leitenden oder halbleitenden Kleber. Diese erste Deposition unter einem ersten Einfallswinkel α bewirkt eine Beschichtung des Substrats, einer Flanke und der Oberseite einer Leiterbahn, wobei ein bestimmter Bereich hinter den Leiterbahnen nicht mit dem Kleber beschichtet wird. In einem bestimmten Abstand hinter den Leiterbahnen erfolgt wieder eine Beschichtung des Substrats, die sich an der Flanke der nächsten Leiterbahn fortsetzt. Die Wahl des Einfallswinkels der Deposition richtet sich nach der Größe der später aufzubringenden kornförmigen Partikel. Damit auf der abgeschatteten Seite der jeweiligen Leiterbahn keine Körner mit der Leiterbahn in Kontakt kommen und haften bleiben, muss der abgeschattete Bereich mindestens so groß sein wie ein Korndurchmesser.

Bei der zweiten Hauptschicht handelt es sich um eine Halbleiterschicht, die durch Aufbringen kornförmiger Partikel gebildet wird. Die Körner werden auf den noch nicht ausgehärteten Kleberbelag aufgebracht und bleiben dort haften. Um eine Isolation zwischen den Körnern zu erreichen, wird eine isolierende Polymerschicht in die Zwischenräume der Körner gebracht. Dies kann beispielsweise durch Tauch- oder Sprühverfahren erfolgen.

Zur Ausbildung eines p/n-Übergangs ist es erforderlich, nun eine n-leitende Schicht aufzubringen. Bei dieser Bufferschicht kann es sich beispielsweise um Cadmiumsulfid handeln, das durch Verfahren der Chemical Bath Deposition aufgebracht wird. Werden für die n-leitende Schicht andere Materialien verwendet, können auch Verfahren wie das Sputtern (PVD), CVD, ALD (Atomic Layer Deposition) zur Anwendung kommen.

Nach der n-leitenden Schicht erfolgt das Aufbringen einer dritten Hauptschicht unter einem Winkel β. Dabei handelt es sich um eine intrinsische Schicht, deren Hauptbestandteil in einer besonders bevorzugten Ausführungsform der Erfindung ZnO ist.

Nach der intrinsischen Schicht erfolgt eine weitere Schichtdeposition unter einem Winkel γ im Bezug zur Substratoberfläche. Bei dieser dritten Hauptschicht handelt es sich um einen leitenden Vorderkontakt Durch die beschriebene Wiederholung von Schichtdepdsitionen unter verschiedenen Winkeln und Aufbringen der Halbleiterschicht in Form von Körnern bildet sich eine Serienverschaltung von Dünn- und/oder Dickschichten aus, die sich insbesondere zur Verwendung für Solarzellen eignet.

Das beschriebene Verfahren zur Herstellung von selbstjustierenden Serienverschaltungen von Dünn- und Dickschichten zeichnet sich durch diverse Vorteile gegenüber herkömmlichen Verfahren aus. Zum einen ist keine absolut präzise Ausrichtung des zu beschichtenden Substrats erforderlich, da der Abschattungsbereich die Trennbereiche bestimmt. Zum anderen kann durch geeignete Aufbringmittel die Schattenbreite und somit der nichtaktive Bereich auf ein Minimum reduziert werden. Ferner ist das Verfahren gut in einem Inline-Prozess durchführbar, da das Substrat nicht zwischen einzelnen Bearbeitungsstationen hin- und her transportiert werden muss, sondern an einer einzigen Station mit geeigneten Aufbringmitteln bearbeitet werden kann. Ein Kreuzen der Trennbereiche ist ebenfalls nicht möglich, so dass Fehlerquellen und Kurzschlüsse ausgeschlossen werden.

Gegenüber herkömmlichen Dünnschichten hat insbesondere die Verwendung einer Dickschicht in Form von kornförmigen Partikeln den Vorteil, dass die Körner als Einzelkristalle erzeugt werden können, was zu besseren elektrischen Eigenschaften führt. Ferner werden durch das verwendete Verfahren Hochtemperatur- und Niedrigtemperaturschritte der üblichen Dünnschichtphotovoltaik getrennt, was zu einer höheren Flexibilität führt.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Abbildungen.

Von den Abbildungen zeigt:
- Fig. 1: ein Ausführungsbeispiel eines Substrats mit aufgebrachten Leiterbahnen;
- Fig. 2: das Aufbringen einer ersten Kleberschicht unter einem Einfallswinkel α;
- Fig. 3: das Aufbringen der Halbleiterschicht in Form von kornförmigen Partikeln;
- Fig. 4: das Aufbringen einer isolierenden Schicht;
- Fig. 5: das Aufbringen einer n-leitenden Bufferschicht;
- Fig. 6: das Aufbringen einer intrinsischen Schicht unter einem Winkel β;
- Fig. 7: das Aufbringen eines Frontkontakts unter einem Winkel γ; und

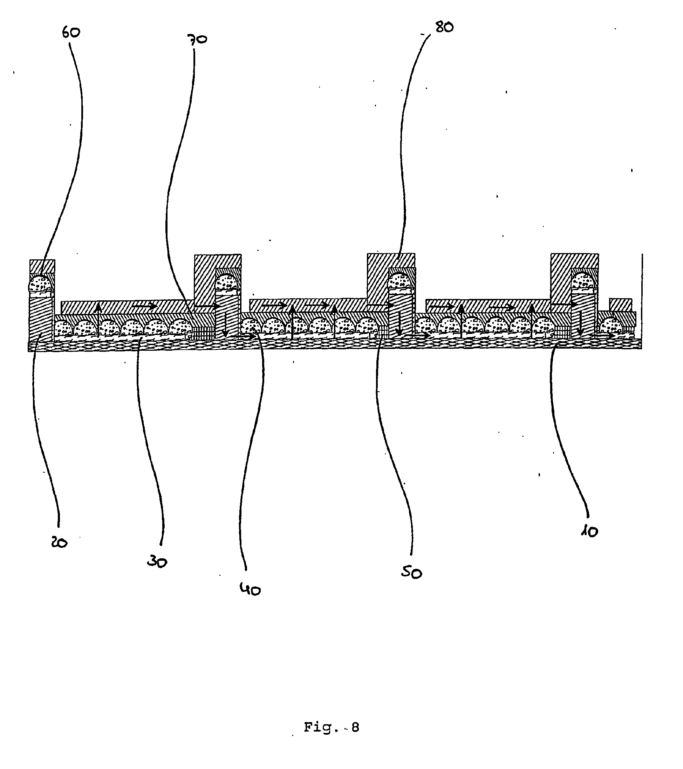

- Fig. 8: den Stromverlauf in der resultierenden Serienverschaltung der Dünn- und Dickschichten.

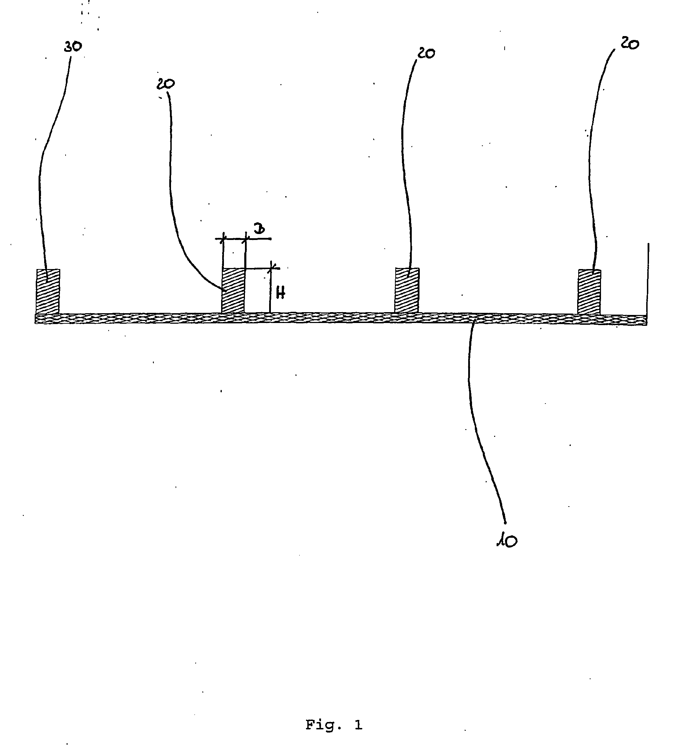

In Fig. 1 ist ein Substrat 10 dargestellt, auf das mehrere im Wesentlichen parallel zueinander verlaufende Leiterbahnen 20 aufgebracht wurden. Dabei umfasst der Ausdruck "im Wesentlichen" exakt parallel verlaufende Leiterbahnen und Leiterbahnen, die um bis zu 50% des Abstands zwischen den Leiterbahnen von der Parallelität abweichen. Bei dem Substrat kann es sich beispielsweise um Glas, insbesondere um Floatglas handeln. Ein weiteres geeignetes Substrat stellt Polymerfolie dar. Die Leiterbahnen 20 sind elektrisch leitfähig und können aus leitfähigen Polymermassen, leitfähigen Glasfritten, metallischen Drähten oder sonstigen Materialien bestehen. Der Querschnitt der Leiterbahnen ist vorzugsweise rechteckig, es können aber auch andere Querschnitte gewählt werden. Beispielsweise können die Leiterbahnen einen dreieckigen, trapezförmigen oder runden Querschnitt aufweisen. Die dreieckigen Leiterbahnen können so aufgebracht werden, dass eine Seitenfläche mit der Substratoberfläche verbunden ist. Trapezförmige Leiterbahnen können beispielsweise so aufgebracht werden, dass sich der Querschnitt zur Substratoberfläche hin verjüngt.

Die Leiterbahnen können beispielsweise mittels Siebdruck aufgebracht werden, wobei die Breite B der Bahnen durch das Sieb und die Eigenschaften der verwendeten Paste bestimmt wird, während die Höhe H vorrangig durch die Anzahl der Druckvorgänge bestimmt wird. Für den Siebdruck kann beispielsweise Graphit- und/oder Silberpaste verwendet werden. Handelt es sich bei den Leiterbahnen um Metallbänder, können diese beispielsweise mit einem leitfähigen Kleber auf das Substrat aufgeklebt werden.

Die resultierenden Abmessungen der Leiterbahnen liegen zweckmäßigerweise in folgenden Größenordnungen: Breite B = 10 µm - 500 µm und Höhe H = 5 µm - 500 µm. Die Länge der Leiterbahnen ist beliebig wählbar und hängt vorrangig von den Abmessungen des zu beschichtenden Substrats ab. Dementsprechend werden Leiterbahnen mit Längen in der Größenordnung von 30 cm bis 6 m verwendet. Die Anzahl der aufgebrachten Leiterbahnen ist daher ebenfalls beliebig wählbar, wobei sie vorzugsweise im Bereich von 50 bis 200 /m liegt. Der Abstand zwischen den einzelnen Leiterbahnen 20 ergibt sich aus den gewählten Abmessungen.

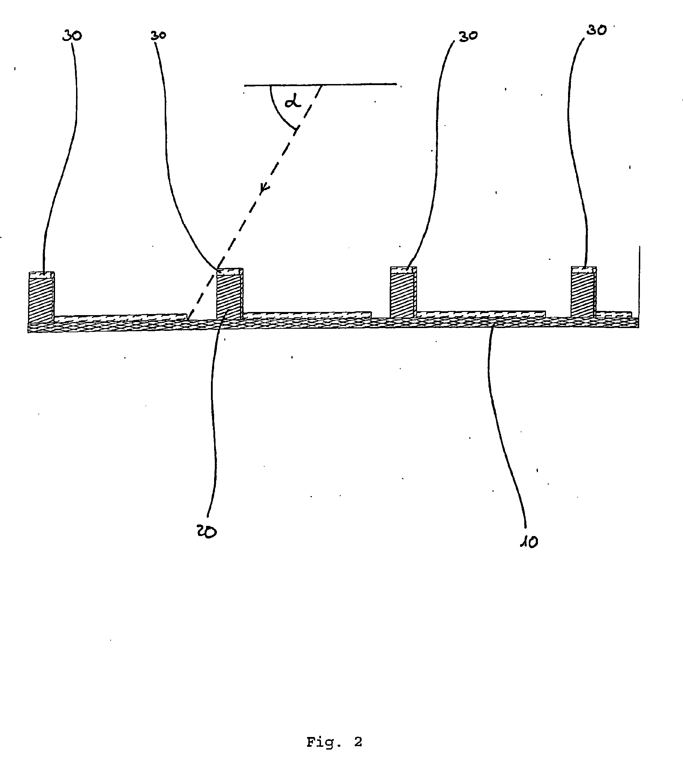

In Fig. 2 ist ein Ausführungsbeispiel dargestellt, bei dem nach dem erfindungsgemäßen Verfahren eine erste Hauptschicht 30 auf das Substrat 10 und die Leiterbahnen 20 aufgebracht wird. Diese erste Schichtdeposition erfolgt unter einem ersten Einfallswinkel α in Bezug auf die Oberfläche des Substrats und zweckmäßigerweise senkrecht zur Längsausrichtung der Leiterbahnen 20. Der Winkel zwischen der Längsausrichtung der Leiterbahnen und der Richtung der Deposition kann jedoch auch von 90° abweichen. Dabei sind Winkel zwischen 90° und 1° möglich.

Die gerichtete Aufbringung des Klebermaterials unter einem Winkel α kann mittels Sprühverfahren oder anderer geeigneter Verfahren erfolgen. Alternativ zur Aufbringung unter, einem Winkel, ist es auch möglich, die Kleberschicht durch andere Verfahren gezielt so aufzubringen, dass hinter den Leiterbahnen 20 Bereiche ohne Kleberschicht entstehen.

Der Abbildung in Fig. 2 ist zu entnehmen, dass durch die Beschichtung unter einem Winkel hinter den Leiterbahnen abgeschattete Bereiche entstehen, die somit keiner Deposition ausgesetzt sind. Es erfolgt daher eine Beschichtung der Oberseiten und der Flanken der Leiterbahnen, die der Deposition ausgesetzt sind, und der Bereiche zwischen den Leiterbahnen, die nicht im Schatten der Leiterbahnen liegen. Die Dicke der so aufgebrachten ersten Schicht liegt typischerweise in der Größenordnung von 50 nm bis 50 µm. nid oder Kupferindiumgalliumdiseleniddisulfid zählen.

Die Aufbringung der Körner erfolgt zweckmäßigerweise vor Aushärtung der ersten Kleberschicht 30, so dass die Körner haften bleiben. Die Körner können beispielsweise durch Streuen, Stäuben und/oder Drucken auf das Substrat aufgebracht werden. Körner ohne Kontakt zur Kleberschicht können durch geeignete Methoden wie Blasen oder Schütteln entfernt werden. Gegebenenfalls kann der Kleber vor Entfernung dieser Körner aushärten. Die Dicke der zweiten Schicht wird vom Durchmesser der verwendeten Körner bestimmt, so dass typische Dicken dieser Hauptschicht in der Größenordnung von 10 µm bis 200 µm liegen.

Die Wahl des Einfallswinkels der Deposition richtet sich nach der Größe der später aufzubringenden kornförmigen Partikel. Es hat sich als zweckmäßig erwiesen, den Aufbringungswinkel α der ersten Depositionsschicht 30 so zu wählen, dass der Abschattungsbereich hinter den Leiterbahnen 20 mindestens einem Durchmesser der Körner 40 entspricht. So ist gewährleistet, dass auf der abgeschatteten Seite der jeweiligen Leiterbahn keine Körner haften bleiben und mit der Leiterbahn in Kontakt kommen.

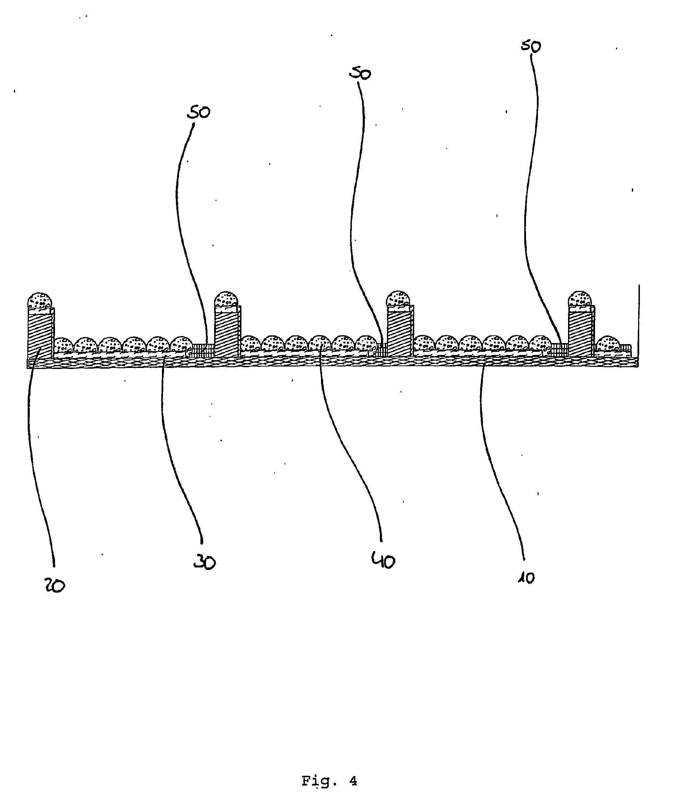

Der Fig. 4 ist zu entnehmen, dass als nächster Verfahrensschritt eine isolierende Schicht 50 auf das Substrat aufgebracht wird, die eine elektrische Isolation in den Zwischenräumen der Körner 40 darstellt. Diese Schicht besteht vorzugsweise aus einem Polymer, bei dem es sich beispielsweise um ein Polymer aus der Gruppe der Epoxide, Polyurethane, Polyacryle und/oder Polyimide handeln kann. Die isolierende Polymerschicht kann beispielsweise durch Tauchen oder Sprühen aufgebracht werden, und die Dicke dieser Schicht liegt typi-Diese erste Hauptschicht bildet den Rückkontakt, der zweckmäßigerweise aus einem leitfähigen Kleber besteht. Als Material für diesen Kleber können Stoffe aus diversen Polymerklassen verwendet werden. Besonders geeignet sind beispielsweise Epoxidharze, Polyurethane, und/oder Polyimide, die mit geeigneten leitfähigen Partikeln wie Kohlenstoff, Indium, Nickel, Molybdän, Eisen, Nickelchrom, Aluminium und/oder entsprechenden Legierungen bzw. Oxiden versehen sind. Eine weitere Möglichkeit stellen intrinsische leitfähige Polymere dar. Dazu zählen beispielsweise Polymere aus der Gruppe der PANis.

Die Wahl des leitfähigen Klebers hängt ferner von der Art des Halbleiters ab, da zwischen Halbleiter und Kleber ein ohm'scher Kontakt bestehen muss. Sollte ein gewählter Kleber zwar einen ohm'schen Kontakt, dafür aber einen schlechten Schichtwiderstand aufweisen, so kann eine solche Kleberschicht durch eine zuvor aufgebrachte höher leitfähige Schicht unterstützt werden. Diese Stützschicht kann wiederum gerichtet unter einem Winkel aufgesputtert werden. Zur Unterstützung der Kleberschicht können vorher auch andere Kleber mit einem besseren Schichtwiderstand aufgebracht werden, welche dann zwar keinen ohm'schen Kontakt zum Halbleiter darstellen, dafür aber eine gute Leitfähigkeit besitzen.

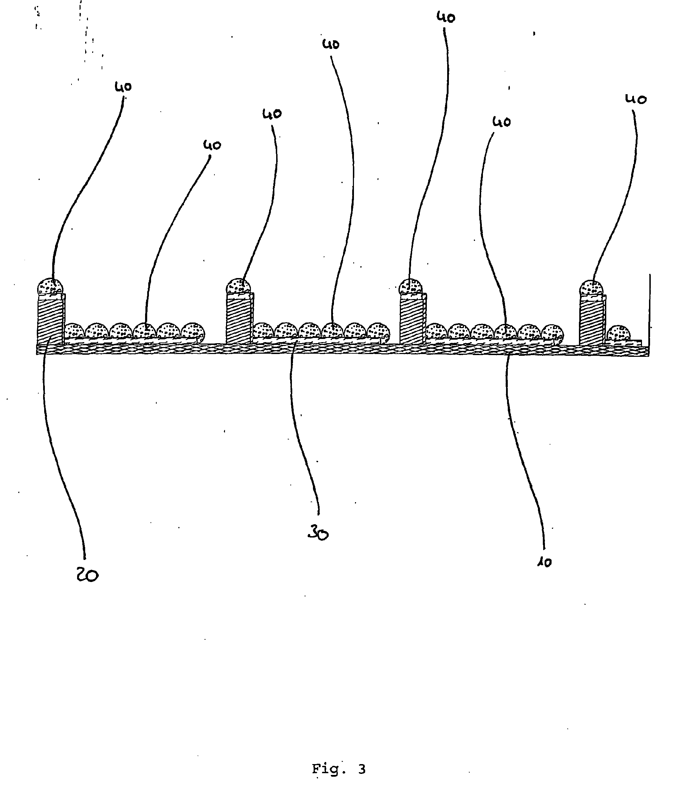

Der Abbildung in Fig. 3 ist zu entnehmen, wie eine Halbleiterschicht in Form von körnigen Partikeln 40 aufgebracht wird. Diese Schicht stellt die zweite Hauptschicht dar. Die Körner haben vorzugsweise eine Korngröße von bis zu 60 µm und bestehen aus geeigneten Halbleitermaterialien der Photovoltaik. In einer besonders bevorzugten Ausführungsform der Erfindung sind die Halbleitermaterialien aus der Klasse der II-VI-Verbindungshalbleiter, zu denen beispielsweise Kupferindiumdiselenid, Kupferindiumdisulfid, Kupferindiumgalliumdiselescherweise in der Größenordnung von 10 bis 70 % des Korndurchmessers, so dass die Körner nicht abgedeckt werden. Die Viskosität des Polymers wird dazu so eingestellt, dass das Material gut von der Oberfläche der Körner abfließt und wenig Material auf der Kornoberfläche zurückbleibt.

Da die Oberfläche der Körner vor dem nächsten Verfahrensschritt kein isolierendes Polymer aufweisen darf, müssen die trotz gering eingestellter Viskosität verbleibenden Reste entfernt werden. Dies kann beispielsweise durch Ätzen mit Laugen oder Säuren, Plasmaätzen oder durch mechanisches Abtragen erfolgen.

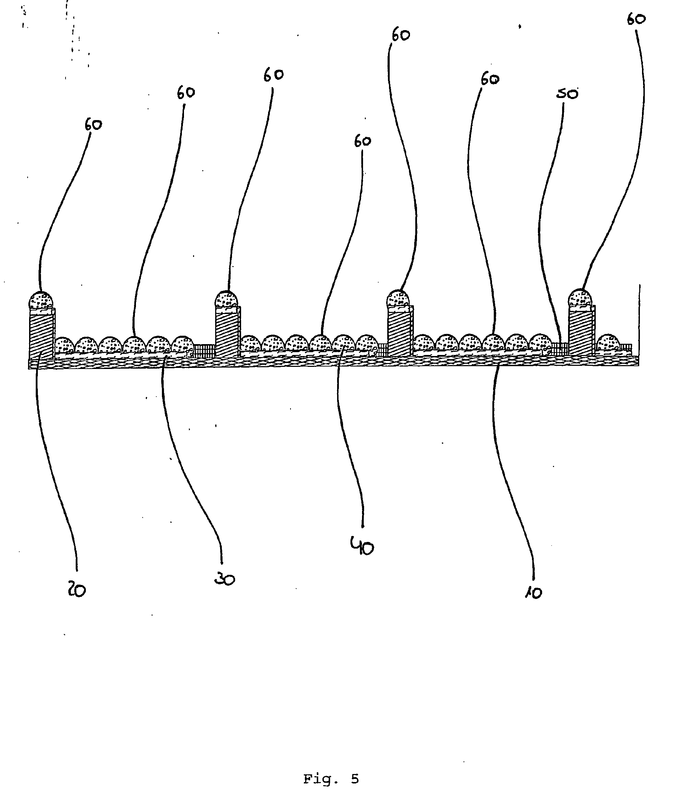

In Fig. 5 ist dargestellt, wie zur Ausbildung eines p/n-Übergangs im nächsten Verfahrensschritt eine n-leitende Schicht 60 aufgebracht wird. Dabei kann es sich beispielsweise um eine Cadmiumsulfid-Schicht handeln. Diese Schicht stellt eine Bufferschicht dar, die abhängig vom gewählten Material durch geeignete Methoden aufgebracht wird. Werden beispielsweise Cadmiumsulfid, In(OH,S) oder ähnliche Materialien verwendet, eignet sich zur Aufbringung das Verfahren der Chemical Bath Deposition. Bei anderen Materialien wie zum Beispiel ZnSe und/oder ZnTe eignet sich das Sputtern. Als weitere Verfahren zur Aufbringung der Bufferschicht sind ferner CVD (Chemical Vapor Deposition), ALD (Atomic Layer Deposition) und ILGAR zu nennen.

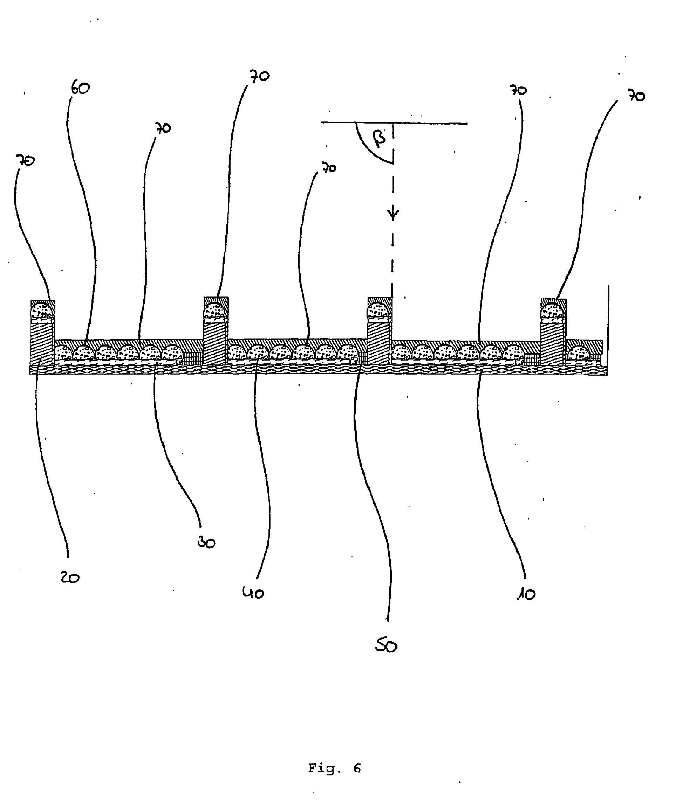

In einer besonders bevorzugten Ausführungsform der Erfindung erfolgt im nächsten Verfahrensschritt, der in Fig. 6 dargestellt ist, die Aufbringung einer intrinsischen Schicht 70 unter einem Winkel β zur Oberfläche des Substrats. Dabei handelt es sich vorzugsweise um ZnO. Als Aufbringmethoden für diese dritte Schicht eignen sich wiederum Sputtern, CVD, ALD oder ILGAR. Es hat sich als zweckmäßig erwiesen, den Winkel β so zu wählen, dass die Flanken der Leiterbahnen, die im ersten Verfahrensschritt der Schicht 30 abgeschattet waren, nun ebenfalls nicht beschichtet werden. Der Winkel sollte jedoch nur gering von 90° abweichen, so dass typische Winkel in der Größenordnung von 70° bis 89° im Bezug zur Substratoberfläche liegen. In der Abbildung in Fig. 6 ist ein Winkel β von 90° dargestellt.

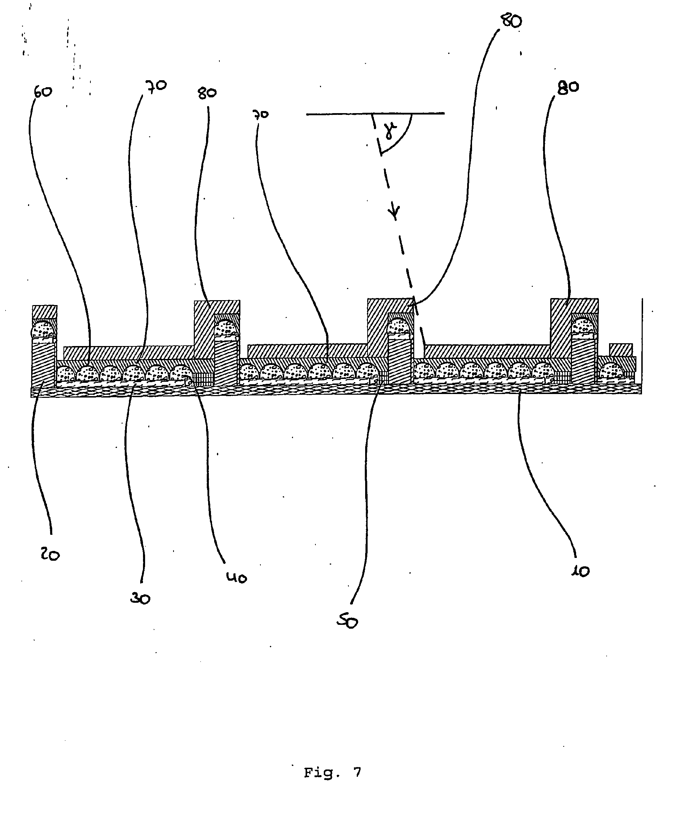

Der Abbildung in Fig. 7 ist zu entnehmen, wie als letzter Verfahrensschritt die Beschichtung mit einem leitenden Vorderkontakt 80 (Frontkontakt) unter einem Winkel γ zur Oberfläche des Substrats erfolgt. Auch diese vierte Hauptschicht kann mit Methoden wie dem Sputtern oder CVD aufgebracht werden. Als Material des Vorderkontakts können beispielsweise diverse TCOs (Transparent Conductive Oxides) eingesetzt werden. Der Winkel γ ist dem Winkel α vorzugsweise entgegengesetzt, so dass die Flanken, die bisher nicht beschichtet wurden, nun einer Deposition ausgesetzt sind.

Das Verfahren ist nun abgeschlossen und die resultierenden Schichten stellen eine Serienverschaltung dar, die beispielsweise für Solarzellen verwendet werden. Der Stromverlauf ist in Fig. 7 durch einen Pfeilverlauf dargestellt.

### Bezugszeichenliste:

- 10: Substrat
- 20: Elektrisch leitfähige Leiterbahnen
- 30: Kleberschicht unter einem Aufbringungswinkel α
- 40: Halbleiterschicht aus kornförmigen Partikeln
- 50: Isolierende Schicht
- 60: n-leitende Bufferschicht
- 70: Intrinsische Schicht unter einem Aufbringungswinkel β
- 80: Vorderkontaktschicht unter einem Aufbringungswinkel γ

## Patentansprüche

1. Verfahren zur Herstellung von selbstjustierenden Serienverschaltungen von Dünn- und/oder Dickschichten, **gekennzeichnet, durch** folgende Verfahrensschritte:
- Aufbringen elektrisch leitfähiger Leiterbahnen (20) auf ein Substrat (10),
- Aufbringen einer ersten Hauptschicht (30) eines leitfähigen Klebermaterials unter einem Winkel α zur Substratoberfläche,
- Aufbringen einer zweiten Hauptschicht aus kornförmigen Partikeln (40), welche an der ersten Hauptschicht haften, auf das Substrat (10),
- Aufbringen mehrerer Schichten verbunden mit material- und prozessabhängigen Bearbeitungschritten,
- Aufbringen einer dritten Hauptschicht (70) unter einem Winkel β zur Substratoberfläche, und
- Aufbringen einer vierten Hauptschicht (80) unter einem Winkel γ zur Substratoberfläche,
- wobei die Winkel α und γ von 90° verschieden und einander entgegengesetzt sind.

2. Verfahren nach Anspruch 1, **dadurch gekennzeichnet, dass** das gerichtete Aufbringen der Hauptschichten (30, 70, 80) unter einem Winkel mittels eines PVD-Verfahrens erfolgt.

3. Verfahren nach einem oder beiden der Ansprüche 1 und 2, **dadurch gekennzeichnet, dass** die Flussrichtung der aufgebrachten Materialteilchen zur Bildung der Hauptschichten (30, 70, 80) senkrecht zur Ausrichtung der Leiterbahnen (20) verläuft.

4. Verfahren nach einem oder mehreren der vorangegangenen Ansprüche, **dadurch gekennzeichnet, dass** die elektrisch leitfähigen Leiterbahnen (20) mittels Siebdruck auf das Substrat (10) aufgebracht werden.

5. Verfahren nach Anspruch 4, **dadurch gekennzeichnet, dass** zur Aufbringung der elektrisch leitfähigen Leiterbahnen (20) mittels Siebdruck Graphit- und/oder Silberpaste verwendet wird.

6. Verfahren nach einem oder mehreren der vorangegangenen Ansprüche, **dadurch gekennzeichnet, dass** die elektrisch leitfähigen Leiterbahnen (20) mit einem leitfähigen Kleber auf das Substrat (10) aufgeklebt werden.

7. Verfahren nach einem oder mehreren der vorangegangenen Ansprüche, **dadurch gekennzeichnet, dass** die kornförmigen Partikel (40) der zweiten Hauptschicht durch Streuen, Stäuben und/oder Drucken aufgebracht werden.

8. Verfahren nach einem oder mehreren der vorangegangenen Ansprüche, **dadurch gekennzeichnet, dass** der Aufbringungswinkel α der ersten Hauptschicht (30) so gewählt ist, dass abhängig von Höhe H und Breite B der Leiterbahnen (20) der Abschattungsbereich an den Flanken der Leiterbahnen wenigstens so breit ist wie der Durchmesser der kornförmigen Partikel (40).

9. Verfahren nach einem oder mehreren der vorangegangenen Ansprüche, **dadurch gekennzeichnet, dass** nach den kornförmigen Partikeln (40) eine isolierende Schicht (50) aufgebracht wird, welche die kornförmigen Partikel (40) zu 10% bis 70% bedeckt.

10. Verfahren nach Anspruch 9, **dadurch gekennzeichnet, dass** die isolierende Schicht (50) durch Tauchen oder Sprühen aufgebracht wird.

11. Verfahren nach einem oder beiden der Ansprüche 9 und 10, **dadurch gekennzeichnet, dass** Material der isolierenden Schicht (50) von den Oberflächen der kornförmigen Partikel (40) entfernt wird.

12. Verfahren nach Anspruch 11, **dadurch gekennzeichnet, dass** Material der isolierenden Schicht (50) durch Ätzverfahren von den Oberflächen der Körner (40) entfernt wird.

13. Verfahren nach Anspruch 11, **dadurch gekennzeichnet, dass** Material der isolierenden Schicht (50) mechanisch von den Oberflächen der Körner (40) entfernt wird.

14. Verfahren nach einem oder mehreren der vorangegangenen Ansprüche 9-13, **dadurch gekennzeichnet, dass** nach Aufbringen der isolierenden Schicht (50) ein p/n-Übergang hergestellt wird.

15. Verfahren nach Anspruch 14, **dadurch gekennzeichnet, dass** nach Aufbringen der isolierenden Schicht (50) eine n-leitende Bufferschicht (60) aufgebracht wird.

16. Verfahren nach einem oder mehreren der vorangegangenen Ansprüche, **dadurch gekennzeichnet, dass** der Aufbringungswinkel β der dritten Hauptschicht (70) in der Größenordnung von 70 bis 89° liegt.

17. Verfahren nach einem oder mehreren der vorangegangenen Ansprüche, **dadurch gekennzeichnet, dass** die Hauptschichten (30, 70, 80) und die Schichten (50, 60) durch Sputter-, CVD-, ALD- und/oder ILGAR-Verfahren und/oder Chemical Bath Deposition aufgebracht werden.

18. Serienverschaltung von Dünn- und/oder Dickschichten, **dadurch gekennzeichnet, dass** sie durch die in den Ansprüchen 1 bis 17 beschriebenen Verfahrensschritte hergestellt wurde.

19. Serienverschaltung nach Anspruch 18, **dadurch gekennzeichnet, dass** das Substrat (10) aus Glas besteht.

20. Serienverschaltung nach Anspruch 19, **dadurch gekennzeichnet, dass** das Substrat (10) aus Floatglas besteht.

21. Serienverschaltung nach Anspruch 18, **dadurch gekennzeichnet, dass** das Substrat (10) aus Polymerfolie besteht.

22. Serienverschaltung nach einem oder mehreren der Ansprüche 18 bis 21, **dadurch gekennzeichnet, dass** die elektrisch leitfähigen Leiterbahnen (20) im Wesentlichen parallel zueinander verlaufen.

23. Serienverschaltung nach einem oder mehreren der Ansprüche 18 bis 22, **dadurch gekennzeichnet, dass** die Abmessungen der elektrisch leitfähigen Leiterbahnen (20) in der Größenordnung Länge L = 30 cm bis 6 m, Höhe H = 5 µm bis 500 µm und Breite B = 10 µm bis 500 µm liegen.

24. Serienverschaltung nach einem oder mehreren der Ansprüche 18 bis 23, **dadurch gekennzeichnet, dass** sich auf der Oberfläche des Substrats (10) 50 bis 200 Leiterbahnen /m befinden.

25. Serienverschaltung nach einem oder mehreren der Ansprüche 18 bis 24, **dadurch gekennzeichnet, dass** die Leiterbahnen (20) aus leitfähigen Polymermassen, leitfähigen Glasfritten oder metallischen Drähten bestehen.

26. Serienverschaltung nach Anspruch 25, **dadurch gekennzeichnet, dass** der Hauptbestandteil der ersten Hauptschicht (30) aus der Gruppe der Polymere ist.

27. Serienverschaltung nach Anspruch 26, **dadurch gekennzeichnet, dass** der Hauptbestandteil der ersten Hauptschicht (30) aus der Gruppe der Epoxidharze, Polyurethane, Polyacryle oder Polyimide ist.

28. Serienverschaltung nach Anspruch 26, **dadurch gekennzeichnet, dass** der Hauptbestandteil der ersten Hauptschicht (30) aus der Gruppe der intrinsischen leitfähigen Polymere (PANis) ist.

29. Serienverschaltung nach einem oder mehreren der vorangegangenen Ansprüche 18 bis 28, **dadurch gekennzeichnet, dass** die kornförmigen Partikel (40) der zweiten Hauptschicht aus Halbleitermaterial bestehen.

30. Serienverschaltung nach Anspruch 29, **dadurch gekennzeichnet, dass** der Durchmesser der kornförmigen Partikel (40) bis zu 60 µm beträgt.

31. Serienverschaltung nach einem oder beiden der Ansprüche 29 und 30, **dadurch gekennzeichnet, dass** die kornförmigen Partikel (40) aus Halbleitermaterialien der Photovoltaik bestehen.

32. Serienverschaltung nach einem oder mehreren der Ansprüche 29 bis 31, **dadurch gekennzeichnet, dass** die kornförmigen Partikel (40) aus Materialien der Klasse der II-VI-Verbindungshalbleiter bestehen.

33. Serienverschaltung nach einem oder mehreren der Ansprüche 29 bis 32, **dadurch gekennzeichnet, dass** die kornförmigen Partikel (40) aus Materialien aus der Gruppe Kupferindiumdiselenid, Kupferindiumdisulfid, Kupferindiumgalliumdiselenid und/oder Kupferindiumgalliumdiseleniddisulfid bestehen.

34. Serienverschaltung nach einem oder mehreren der Ansprüche 18 bis 33, **dadurch gekennzeichnet, dass** die isolierende Schicht (50) aus einem Polymer besteht.

35. Serienverschaltung nach Anspruch 34, **dadurch gekennzeichnet, dass** der Hauptbestandteil der isolierenden Schicht (50) ein Polymer aus der Gruppe der Epoxidharze, Polyurethane, Polyacryle oder Polyimide ist.

36. Serienverschaltung nach einem oder mehreren der Ansprüche 18 bis 35, **dadurch gekennzeichnet, dass** die n-leitende Bufferschicht (80) aus Cadmiumsulfid, ZnSe oder ZnTe besteht.

37. Serienverschaltung nach einem oder mehreren der Ansprüche 18 bis 36, **dadurch gekennzeichnet, dass** die dritte Hauptschicht (70) aus ZnO besteht.

38. Serienverschaltung nach einem oder mehreren der Ansprüche 18 bis 37, **dadurch gekennzeichnet, dass** die vierte Hauptschicht (80) einen Vorderkontakt bildet.

39. Serienverschaltung nach Anspruch 38, **dadurch gekennzeichnet, dass** die vierte Hauptschicht (80) aus einem TCO (Transparent Conductive Oxide) besteht.

## Claims

1. A method for the production of self-adjusting serial connections of thick and/or thin layers, **characterized by** the following process steps:
• electrically conductive conductor tracks (20) are applied onto a substrate (10),
• a first main layer (30) of a conductive adhesive material is applied at an angle α relative to the surface of the substrate,
• a second main layer of granular particles (40), which adhere to the first main layer, is applied onto the substrate (10),
• several layers are applied in conjunction with material-dependent and process-dependent processing steps,
• a third main layer (70) is applied at an angle β relative to the surface of the substrate,
• a fourth main layer (80) is applied at an angle γ relative to the surface of the substrate,
• whereby the angles α and γ are different from 90° and are inverse to each other.

2. The method according to Claim 1, **characterized in that** the targeted application of the main layers (30, 70, 80) is carried out at an angle by means of a PVD process.

3. The method according to one or both of Claims 1 and 2, **characterized in that**, in order to form the main layers (30, 70, 80), the flux direction of the applied material particles runs perpendicular to the orientation of the conductor tracks (20).

4. The method according to one or more of the preceding claims, **characterized in that** the electrically conductive conductor tracks (20) are applied onto the substrate (10) by means of silk screen printing.

5. The method according to Claim 4, **characterized in that** graphite and/or silver paste is used to apply the electrically conductive conductor tracks (20) by means of silk screen printing.

6. The method according to one or more of the preceding claims, **characterized in that** the electrically conductive conductor tracks (20) are glued onto the substrate (10) by means of a conductive adhesive.

7. The method according to one or more of the preceding claims, **characterized in that** the granular particles (40) of the second main layer are applied by sprinkling, dusting and/or printing.

8. The method according to one or more of the preceding claims, **characterized in that** the application angle α of the first main layer (30) is selected in such a way that, depending on the height H and the width W of the conductor tracks (20), the shading area on the flanks of the conductor tracks is at least as wide as the diameter of the granular particles (40).

9. The method according to one or more of the preceding claims, **characterized in that**, after the granular particles (40), an insulating layer (50) is applied that covers 10% to 70% of the granular particles (40).

10. The method according to Claim 9, **characterized in that** the insulating layer (50) is applied by dipping or spraying.

11. The method according to one or both of Claims 9 and 10, **characterized in that** material of the insulating layer (50) is removed from the surfaces of the granular particles (40).

12. The method according to Claim 11, **characterized in that** material of the insulating layer (50) is removed from the surfaces of the grains (40) by etching methods.

13. The method according to Claim 11, **characterized in that** material of the insulating layer (50) is removed from the surfaces of the grains (40) mechanically.

14. The method according to one or more of the preceding Claims 9 to 13, **characterized in that,** after the application of the insulating layer (50), a p/n transition is created.

15. The method according to Claim 14, **characterized in that**, after the application of the insulating layer (50), an n-conductive buffer layer (60) is applied.

16. The method according to one or more of the preceding claims, **characterized in that** the application angle β of the third main layer (70) is in the order of magnitude of 70° to 89°.

17. The method according to one or more of the preceding claims, **characterized in that** the main layers (30, 70, 80) and the layers (50, 60) are applied by means of sputtering, CVD, ALD and/or ILGAR methods and/or by chemical bath deposition.

18. A serial connection of thick and/or thin layers, **characterized in that** they were made by the process steps described in Claims 1 to 17.

19. The serial connection according to Claim 18, **characterized in that** the substrate (10) is made of glass.

20. The serial connection according to Claim 19, **characterized in that** the substrate (10) is made of float glass.

21. The serial connection according to Claim 18, **characterized in that** the substrate (10) is made of polymer film.

22. The serial connection according to one or more of Claims 18 to 21, **characterized in that** the electrically conductive conductor tracks (20) run essentially parallel to each other.

23. The serial connection according to one or more of Claims 18 to 22, **characterized in that** the dimensions of the electrically conductive conductor tracks (20) are in the order of magnitude of length L = 30 cm to 6 meters, height H = 5 µm to 500 µm and width W = 10 µm to 500 µm.

24. The serial connection according to one or more of Claims 18 to 23, **characterized in that** there are 50 to 200 conductor tracks per meter on the surface of the substrate (10).

25. The serial connection according to one or more of Claims 18 to 24, **characterized in that** the conductor tracks (20) are made of conductive polymer compounds, conductive glass frits or metallic wires.

26. The serial connection according to Claim 25, **characterized in that** the main component of the first main layer (30) is from the group consisting of polymers.

27. The serial connection according to Claim 26, **characterized in that** the main component of the first main layer (30) is from the group consisting of epoxide resins, polyurethanes, polyacrylics and/or polyimides.

28. The serial connection according to Claim 26, **characterized in that** the main component of the first main layer (30) is from the group consisting of intrinsic conductive polymers (PAN's).

29. The serial connection according to one or more of the preceding Claims 18 to 28, **characterized in that** the granular particles (40) of the second main layer are made of semiconductive material.

30. The serial connection according to Claim 29, **characterized in that** the diameter of the granular particles (40) is up to 60 µm.

31. The serial connection according to one or both of Claims 29 and 30, **characterized in that** the granular particles (40) are made of semiconductor materials from the realm of photovoltaics.

32. The serial connection according to one or more Claims 29 to 31, **characterized in that** the granular particles (40) are made of materials from the class of II-VI compound semiconductors.

33. The serial connection according to one or more Claims 29 to 32, **characterized in that** the granular particles (40) are made of materials from the group consisting of copper indium diselenide, copper indium disulfide, copper indium gallium diselenide and/or copper indium gallium diselenide disulfide.

34. The serial connection according to one or more Claims 18 to 33, **characterized in that** the insulating layer (50) is made of a polymer.

35. The serial connection according to Claim 34, **characterized in that** the main component of the insulating layer (50) is a polymer from the group consisting of epoxide resins, polyurethanes, polyacrylics and/or polyimides.

36. The serial connection according to one or more Claims 18 to 35, **characterized in that** the n-conductive buffer layer (80) is made of cadmium sulfide, ZnSe or ZnTe.

37. The serial connection according to one or more Claims 18 to 36, **characterized in that** the third main layer (70) is made of ZnO.

38. The serial connection according to one or more Claims 18 to 37, **characterized in that** the fourth main layer (80) forms a front contact.

39. The serial connection according to Claim 38, **characterized in that** the fourth main layer (80) is made of a TCO (transparent conductive oxide).

## Revendications

1. Procédé pour réaliser des connexions en série à ajustage automatique de couches minces et/ou épaisses, **caractérisé par** les étapes suivantes:
- application de pistes conductrices (20) électriquement conductrices sur un substrat (10),
- application d'une première couche principale (30) d'une matière collante conductrice avec un angle α par rapport à la surface du substrat,
- application, sur le substrat (10), d'une deuxième couche principale composée de particules granuleuses (40) qui adhèrent à la première couche principale,
- application de plusieurs couches conjointement avec des étapes de traitement qui sont fonction des matières et des processus,
- application d'une troisième couche principale (70) avec un angle β par rapport à la surface du substrat et
- application d'une quatrième couche principale (80) avec un angle γ par rapport à la surface du substrat,
- les angles α et γ différant de 90° et étant opposés l'un à l'autre.

2. Procédé selon la revendication 1, **caractérisé en ce que** l'application dirigée des couches principales (30, 70, 80) avec un angle se fait au moyen d'un procédé PVD.

3. Procédé selon l'une des ou selon les deux revendications 1 et 2, **caractérisé en ce que** le sens du flux des particules de matière appliquées pour former les couches principales (30, 70, 80) est perpendiculaire à l'orientation des pistes conductrices (20).

4. Procédé selon l'une ou plusieurs des revendications précédentes, **caractérisé en ce que** les pistes conductrices (20) électriquement conductrices sont appliquées sur le substrat (10) par sérigraphie.

5. Procédé selon la revendication 4, **caractérisé en ce qu'**est utilisée, pour l'application des pistes conductrices (20) électriquement conductrices par sérigraphie, une pâte de graphite et/ou d'argent.

6. Procédé selon l'une ou plusieurs des revendications précédentes, **caractérisé en ce que** les pistes conductrices (20) électriquement conductrices sont collées sur le substrat (10) avec une colle conductrice.

7. Procédé selon l'une ou plusieurs des revendications précédentes, **caractérisé en ce que** les particules granuleuses (40) de la deuxième couche principale sont appliquées par épandage, saupoudrage et/ou impression.

8. Procédé selon l'une ou plusieurs des revendications précédentes, **caractérisé en ce que** l'angle d'application α de la première couche principale (30) est choisi de manière telle que, en fonction de la hauteur H et de la largeur B des pistes conductrices (20), la zone d'occultation sur les flancs des pistes conductrices est au moins aussi large que le diamètre des particules granuleuses (40).

9. Procédé selon l'une ou plusieurs des revendications précédentes, **caractérisé en ce qu'**est appliquée, après les particules granuleuses (40), une couche isolante (50) qui recouvre les particules granuleuses (40) à concurrence de 10% à 70%.

10. Procédé selon la revendication 9, **caractérisé en ce que** la couche isolante (50) est appliquée par immersion ou aspersion.

11. Procédé selon l'une des ou selon les deux revendications 9 et 10, **caractérisé en ce que** la matière de la couche isolante (50) est enlevée des surfaces des particules granuleuses (40).

12. Procédé selon la revendication 11, **caractérisé en ce que** la matière de la couche isolante (50) est enlevée des surfaces des grains (40) par un procédé de gravure.

13. Procédé selon la revendication 11, **caractérisé en ce que** la matière de la couche isolante (50) est enlevée mécaniquement des surfaces des grains (40).

14. Procédé selon l'une ou plusieurs des revendications précédentes 9 à 13, **caractérisé en ce qu'**une transition p/n est réalisée après l'application de la couche isolante (50).

15. Procédé selon la revendication 14, **caractérisé en ce qu'**est appliquée, après l'application de la couche isolante (50), une couche tampon (60) n conductrice.

16. Procédé selon l'une ou plusieurs des revendications précédentes, **caractérisé en ce que** l'angle d'application β de la troisième couche principale (70) est de l'ordre de grandeur de 70 à 89°.

17. Procédé selon l'une ou plusieurs des revendications précédentes, **caractérisé en ce que** les couches principales (30, 70, 80) et les couches (50, 60) sont appliquées par des procédés de sputtering, CVD, ALD et/ou ILGAR et/ou par dépôt en bain chimique (Chemical Bath Deposition).

18. Connexion en série de couches minces et/ou épaisses, **caractérisée en ce qu'**elle a été réalisée par les étapes de procédé décrites dans les revendications 1 à 17.

19. Connexion en série selon la revendication 18, **caractérisée en ce que** le substrat (10) se compose de verre.

20. Connexion en série selon la revendication 19, **caractérisée en ce que** le substrat (10) se compose de verre flotté.

21. Connexion en série selon la revendication 18, **caractérisée en ce que** le substrat (10) se compose d'une feuille de polymère.

22. Connexion en série selon l'une ou plusieurs des revendications 18 à 21, **caractérisée en ce que** les pistes conductrices (20) électriquement conductrices sont sensiblement parallèles entre elles.

23. Connexion en série selon l'une ou plusieurs des revendications 18 à 22, **caractérisée en ce que** les dimensions des pistes conductrices (20) électriquement conductrices sont de l'ordre de grandeur suivant: longueur L = 30 cm à 6 m, hauteur H = 5 µm à 500 µm et largeur B = 10 µm à 500 µm.

24. Connexion en série selon l'une ou plusieurs des revendications 18 à 23, **caractérisée en ce que** se trouvent, sur la surface du substrat (10), 50 à 200 pistes conductrices /m.

25. Connexion en série selon l'une ou plusieurs des revendications 18 à 24, **caractérisée en ce que** les pistes conductrices (20) se composent de masses polymères conductrices, de frittes de verre conductrices ou de fils métalliques.

26. Connexion en série selon la revendication 25, **caractérisée en ce que** le composant principal de la première couche principale (30) est du groupe des polymères.

27. Connexion en série selon la revendication 26, **caractérisée en ce que** le composant principal de la première couche principale (30) est du groupe des résines époxy, des polyuréthanes, des polyacryls ou des polyimides.

28. Connexion en série selon la revendication 26, **caractérisée en ce que** le composant principal de la première couche principale (30) est du groupe des polymères intrinsèques conducteurs (PANis)

29. Connexion en série selon l'une ou plusieurs des revendications précédentes 18 à 28, **caractérisée en ce que** les particules granuleuses (40) de la deuxième couche principale se compose d'un matériau semi-conducteur.

30. Connexion en série selon la revendication 29, **caractérisée en ce que** le diamètre des particules granuleuses (40) va jusqu'à 60 µm.

31. Connexion en série selon l'une des ou les deux revendications 29 et 30, **caractérisée en ce que** les particules granuleuses (40) se composent de matériaux semi-conducteurs de la photovoltaïque.

32. Connexion en série selon l'une ou plusieurs des revendications 29 à 31, **caractérisée en ce que** les particules granuleuses (40) se composent de matériaux de la classe des semi-conducteurs de liaison II-VI.

33. Connexion en série selon l'une ou plusieurs des revendications 29 à 32, **caractérisée en ce que** les particules granuleuses (40) se composent de matériaux du groupe du diséléniure de cuivre et d'indium, du disulfure de cuivre et d'indium, du diséléniure de cuivre, d'indium et de gallium et/ou du disulfure diséléniure de cuivre, d'indium et de gallium.

34. Connexion en série selon l'une ou plusieurs des revendications 18 à 33, **caractérisée en ce que** la couche isolante (50) se compose d'un polymère.

35. Connexion en série selon la revendication 34, **caractérisée en ce que** le composant principal de la couche isolante (50) est un polymère du groupe des résines époxy, des polyuréthanes, des polyacryls ou des polyimides.

36. Connexion en série selon l'une ou plusieurs des revendications 18 à 35, **caractérisée en ce que** la couche tampon (80) n conductrice se compose de sulfure de cadmium, de ZnSe ou de ZnTe.

37. Connexion en série selon l'une ou plusieurs des revendications 18 à 36, **caractérisée en ce que** la troisième couche principale (70) se compose de ZnO.

38. Connexion en série selon l'une ou plusieurs des revendications 18 à 37, **caractérisée en ce que** la quatrième couche principale (80) constitue un contact avant.

39. Connexion en série selon la revendication 38, **caractérisée en ce que** la quatrième couche principale (80) se compose d'un oxyde transparent conducteur (TCO, Transparent Conductive Oxide).
